# EUROPEAN PATENT APPLICATION

(11) **EP 2 506 307 A1**
(43) Date of publication of application: **03.10.2012**
(21) Application number: 10832906.1
(22) Date of filing: 21.07.2010
(51) Int. Cl.: H01L 29/786, G02F 1/136, G02F 1/1368, H01L 21/28, H01L 21/336, H01L 21/768, H01L 27/146

(54) **THIN FILM TRANSISTOR AND MANUFACTURING METHOD FOR SAME, SEMICONDUCTOR DEVICE AND MANUFACTURING METHOD FOR SAME, AND DISPLAY DEVICE**

(30) Priority: 27.11.2009 JP 2009269559
(71) Applicant: Sharp Kabushiki Kaisha, Osaka-shi, Osaka 545-8522 (JP)
(72) Inventor: TOMIYASU, Kazuhide, Osaka 545-8522 (JP); KITAKADO, Hidehito, Osaka 545-8522 (JP); MIYAMOTO, Tadayoshi, Osaka 545-8522 (JP)
(74) Representative: Müller - Hoffmann & Partner
(86) International application number: PCT/JP2010/062218
(87) International publication number: WO 2011/065059

(57) **Abstract**

An object of the present invention is to provide a thin film transistor fabricating method including a simplified step of forming contact holes. This method involves previously removing a gate insulating film (115) on a gate electrode (110) which is not covered with a channel layer (120) in a TFT (100). Hence, an insulating film formed on the gate electrode (110) which is not covered with the channel layer (120) becomes equal in thickness to an insulating film formed on a source region (120a) and a drain region (120b). Therefore, a contact hole (155) reaching a surface of the gate electrode (110) can be formed simultaneously with a contact hole (135a) reaching a surface of the source region (120a) and a contact hole (135b) reaching a surface of the drain region (120b).

## Description

### TECHNICAL FIELD

The present invention relates to a thin film transistor and a method for fabricating the same, a semiconductor device and a method for fabricating the same, as well as a display. More specifically, the present invention relates to a thin film transistor having a bottom gate structure and a method for fabricating the same, a semiconductor device and a method for fabricating the same, as well as a display.

### BACKGROUND ART

In a fabricating process of a thin film transistor (TFT) having a bottom gate structure, it is required to etch an insulating film called a cap film and an interlayer insulating film formed on a surface of the cap film in a case of forming contact holes for electrically connecting a source electrode and a drain electrode to a source region and a drain region, respectively. On the other hand, a gate insulating film, the cap film and the interlayer insulating film are laminated sequentially on a surface of a gate electrode which is not covered with a channel layer. Therefore, it is required to etch not only the cap film and the interlayer insulating film, but also the gate insulating film in order to electrically connect a wiring layer to the gate electrode via a contact hole. As described above, in the TFT having the bottom gate structure, the insulating film on the gate electrode which is not covered with the channel layer is larger in thickness than the insulating film on the source region and the drain region by a thickness of the gate insulating film. Therefore, it is difficult to simultaneously form the contact holes on the source region and the drain region and the contact hole on the gate electrode in one step. Heretofore, these contact holes have been formed in separate steps, respectively.

Japanese Patent Application Laid-Open No. 2001-320056 discloses a TFT having a bottom gate structure. Also in this TFT, it is supposed that an insulating film on a gate electrode which is not covered with a channel layer is different in thickness from that on a source region and a drain region. Therefore, it is supposed that a contact hole on the gate electrode and contact holes on the source region and the drain region are formed in separate steps, respectively.

### PRIOR ART DOCUMENT

### PATENT DOCUMENT

Patent Document 1: Japanese Patent Application Laid-Open No. 2001-320056

### SUMMARY OF THE INVENTION

### PROBLEMS TO BE SOLVED BY THE INVENTION

However, a TFT fabricating process becomes complicated when a step of forming contact holes on a source region and a drain region, respectively, and a step of forming a contact hole on a gate electrode are provided separately. As the result, there arises a problem that a yield decreases because of the prolongation of a TAT (Turn Around Time). In addition, there also arises a problem that a fabricating cost becomes high because of the increase of the number of photomasks to be used.

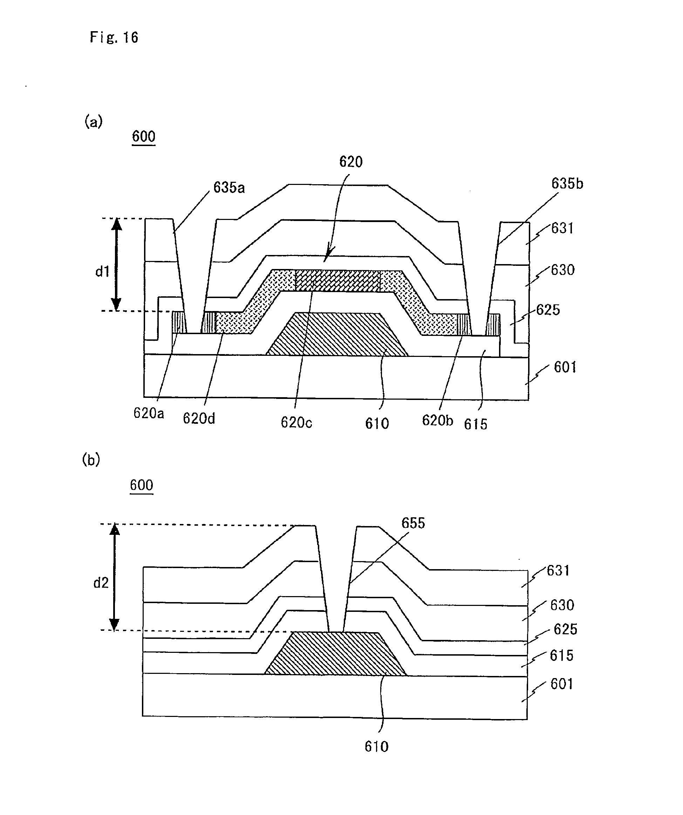

Moreover, the fabricating process can be simplified in such a manner that the contact holes are formed on the source region and the drain region, respectively, and the contact hole is formed on the gate electrode which is not covered with the channel layer, in one step. However, there arise the following problems. Fig. 16(a) is a section view that shows shapes of contact holes 635a and 635b in a source region 620a and a drain region 620b in a conventional TFT 600. Fig. 16(b) is a section view that shows a shape of a contact hole 655 on a gate electrode 610 which is not covered with a channel layer 620 in the conventional TFT 600.

As shown in Fig. 16(a), in the TFT 600, the gate electrode 610, a gate insulating film 615 and the channel layer 620 are formed sequentially on a glass substrate 601. The source region 620a and the drain region 620b are formed in left and right end portions of the channel layer 620, respectively, and a channel region 620c is formed in a center portion of the channel layer 620. A cap film 625 and first and second interlayer insulating films 630 and 631 are laminated sequentially on a surface of the channel layer 620. As shown in Fig. 16(b), on the other hand, in a region where the contact hole 655 on the gate electrode 610 which is not covered with the channel layer 620 is formed (hereinafter, referred to as a "gate contact region"), the gate insulating film 615 is further laminated between the cap film 625 and the gate electrode 610. As the result, a thickness d2 of the insulating film on the gate electrode 610 becomes larger than a thickness d1 of the insulating film on the source region 620a and the drain region 620b.

In the case where the contact holes 635a and 635b are formed on the source region 620a and the drain region 620b, respectively, and simultaneously the contact hole 655 is formed on the gate electrode 610, at the time when the contact holes 635a and 635b reach surfaces of the source region 620a and drain region 620b, respectively, the contact hole 655 can only reach up to a portion near a surface of the gate insulating film 615. Further, when etching is performed until the contact hole 655 reaches a surface of the gate electrode 610, the etching of the source region 620a and the drain region 620b proceeds in the contact holes 635a and 635b. As the result, the source region 620a and drain region 620b are thinned excessively in the contact holes 635a and 635b. Further, the source region 620a and the drain region 620b are removed entirely in some instances. In this case, there arises a problem that contact resistance between a source electrode (not shown) and the source region 620a and contact resistance between a drain electrode (not shown) and the drain region 620b increase.

Hence, one object of the present invention is to provide a thin film transistor fabricating method including a simplified step of forming contact holes. Moreover, another object of the present invention is to provide a thin film transistor in which contact resistance between a source region and a source electrode and contact resistance between a drain region and a drain electrode do not increase.

### SOLUTIONS TO THE PROBLEMS

A first aspect of the present invention provides a bottom gate type thin film transistor formed on an insulation substrate, the thin film transistor including: a first gate electrode formed on the insulation substrate; a channel layer formed so as to partially cover the first gate electrode; a gate insulating film formed below the channel layer; a source region and a drain region each formed in the channel layer; a first insulating film formed on surfaces of the source region and drain region; a second insulating film formed on a surface of the first gate electrode which is not covered with the channel layer; first contact holes formed in the first insulating film to reach the surfaces of the source region and drain region, respectively; and a second contact hole formed in the second insulating film to reach the surface of the first gate electrode which is not covered with the channel layer, wherein the first insulating film is equal in thickness to the second insulating film.

A second aspect of the present invention provides the thin film transistor according to the first aspect of the present invention, further including a second gate electrode formed on the first insulating film so as to be opposed to the first gate electrode with the channel layer interposed in between.

A third aspect of the present invention provides a method for fabricating a bottom gate type thin film transistor formed on an insulation substrate, the method including the steps of: forming a gate electrode on the insulation substrate; forming a gate insulating film so as to cover the insulation substrate together with the gate electrode; forming a semiconductor film on the gate insulating film; etching the semiconductor film and the gate insulating film to form a channel layer which partially covers the gate electrode and extends onto the gate insulating film and, simultaneously, to remove the semiconductor film and the gate insulating film on the gate electrode which is not covered with the channel layer; doping the channel layer with impurities to form a source region and a drain region; forming an insulating film so as to cover the insulation substrate together with the channel layer and the gate electrode; and etching the insulating film to simultaneously form first contact holes reaching surfaces of the source region and drain region, respectively, and a second contact hole reaching a surface of the gate electrode from which the gate insulating film is removed.

A fourth aspect of the present invention provides the method for fabricating the thin film transistor according to the third aspect of the present invention, wherein the step of forming the source region and the drain region includes a step of doping the channel layer with the impurities after etching the semiconductor film to form the channel layer.

A fifth aspect of the present invention provides the method for fabricating the thin film transistor according to the third aspect of the present invention, wherein the step of forming the source region and the drain region includes a step of doping the semiconductor film with the impurities before etching the semiconductor film to form the channel layer.

A sixth aspect of the present invention provides a semiconductor device including: one insulation substrate; a thin film transistor formed on the insulation substrate; and a photodiode having a light shielding film and formed on the insulation substrate, wherein the thin film transistor includes: a gate electrode formed on the insulation substrate; a channel layer formed so as to partially cover the gate electrode; a gate insulating film formed below the channel layer; a source region and a drain region each formed in the channel layer; a first insulating film formed on surfaces of the source region and drain region; a second insulating film formed on a surface of the gate electrode which is not covered with the channel layer; first contact holes formed in the first insulating film to reach the surfaces of the source region and drain region, respectively; and a second contact hole formed in the second insulating film to reach the surface of the gate electrode which is not covered with the channel layer, the photodiode includes: the light shielding film formed on the insulation substrate; an island-shaped semiconductor layer formed on the light shielding film with the gate insulating film interposed in between; an anode region and a cathode region each formed in the island-shaped semiconductor layer; and a third insulating film in which third contact holes reaching surfaces of the anode region and cathode region, respectively, are formed, and the first insulating film, the second insulating film and the third insulating film are equal in thickness to one another.

A seventh aspect of the present invention provides a method for fabricating a semiconductor device in which a thin film transistor and a photodiode having a light shielding film are formed on one insulation substrate, the method comprising the steps of: forming a gate electrode of the thin film transistor and the light shielding film on the insulation substrate; forming a gate insulating film so as to cover the insulation substrate together with the gate electrode and the light shielding film; forming a semiconductor film on the gate insulating film; performing patterning on the semiconductor film to form a channel layer, which partially covers the gate electrode and extends onto the gate insulating film, of the thin film transistor and an island-shaped semiconductor layer of the photodiode and, simultaneously, to remove the semiconductor film and the gate insulating film on the gate electrode which is not covered with the channel layer; forming a source region and a drain region in the channel layer, and forming a cathode region and an anode region in the island-shaped semiconductor layer; forming an insulating film so as to cover the insulation substrate together with the channel layer, the island-shaped semiconductor layer, and the gate electrode from which the gate insulating film is removed; and etching the insulating film to simultaneously form first contact holes reaching surfaces of the source region and drain region, respectively, a second contact hole reaching a surface of the gate electrode from which the gate insulating film is removed, and third contact holes reaching surfaces of the cathode electrode and anode electrode, respectively.

An eighth aspect of the present invention provides an active matrix type display for displaying an image, the display including: a display part including a plurality of gate wires, a plurality of source wires intersecting the plurality of gate wires, and a plurality of pixel formation parts arranged in a matrix form in correspondence with intersections between the plurality of gate wires and the plurality of source wires; a gate driver selectively activating the plurality of gate wires; and a source driver applying to the source wire an image signal indicating an image to be displayed, wherein the pixel formation part includes a switching element to be turned on and off in accordance with a signal applied to the corresponding gate wire, and the switching element is the thin film transistor according to the first aspect.

A ninth aspect of the present invention provides an active matrix type display having a touch panel function, the display including: a display part including a plurality of gate wires, a plurality of source wires intersecting the plurality of gate wires, and a plurality of pixel formation parts arranged in a matrix form in correspondence with intersections between the plurality of gate wires and the plurality of source wires, each pixel forming part including the semiconductor device according to the sixth aspect of the present invention; a gate driver selectively activating the plurality of gate wires; a source driver applying to the source wire an image signal indicating an image to be displayed; and a position detector circuit detecting a touched position on the display part, wherein each of the plurality of pixel formation parts includes: a switching element to be turned on and off in accordance with a signal applied to the corresponding gate wire; and a photoreceptor part outputting to the position detector circuit a signal responsive to the intensity of light to be incident into the pixel formation part, the switching element is a thin film transistor included in the semiconductor device, and the photoreceptor part is a photodiode included in the semiconductor device.

### EFFECTS OF THE INVENTION

According to the first aspect of the present invention, the gate insulating film is not formed on the gate electrode which is not covered with the channel layer. For this reason, in the thin film transistor, the thickness of the first insulating film formed on the surfaces of the source region and drain region becomes equal to the thickness of the second insulating film formed on the surface of the gate electrode which is not covered with the channel layer. Therefore, it is possible to simultaneously form the first contact holes reaching the surfaces of the source region and drain region, respectively, and the second contact hole reaching the surface of the gate electrode. Thus, there is no possibility that the source region and the drain region in the first contact holes are thinned excessively or removed entirely at the time of forming the second contact hole. As the result, it is possible to prevent contact resistance between the source region and the source electrode and contact resistance between the drain region and the drain electrode from increasing.

According to the second aspect of the present invention, also in the double gate type thin film transistor, it is possible to prevent the contact resistance between the source region and the source electrode and the contact resistance between the drain region and the drain electrode from increasing, as in the first aspect.

According to the third aspect of the present invention, the semiconductor film and the gate insulating film on the gate electrode which is not covered with the channel layer are further removed at the time of etching the semiconductor film to form the channel layer. Then, the insulating film is formed so as to cover the insulation substrate together with the channel layer and the gate electrode. As the result, the thickness of the insulating film on the source region and the drain region each formed in the channel layer becomes equal to the thickness of the insulating film on the gate electrode which is not covered with the channel layer. For this reason, it is possible to form the first contact holes reaching the surfaces of the source region and drain region and the second contact hole reaching the surface of the gate electrode in one step. Thus, it is possible to simplify the step of forming the contact holes in the thin film transistor.

According to the fourth aspect of the present invention, it is possible to simplify the step of forming the contact holes in the thin film transistor.

According to the fifth aspect of the present invention, it is possible to simplify the step of forming the contact holes in the thin film transistor.

According to the sixth aspect of the present invention, the gate insulating film is not formed on the gate electrode which is not covered with the channel layer in the thin film transistor. In the thin film transistor and the photodiode, therefore, the thickness of the first insulating film on the source region and the drain region, the thickness of the insulating film on the gate electrode which is not covered with the channel layer, and the thickness of the third insulating film on the anode region and the cathode region become equal to one another. Thus, it is possible to simultaneously form the first contact holes reaching the surfaces of the source region and drain region, the second contact hole reaching the surface of the gate electrode, and the third contact holes reaching the surfaces of the anode region and cathode region. Therefore, there is no possibility that the source region and the drain region in the first contact holes and the anode region and the cathode region in the third contact holes are thinned excessively or removed entirely at the time of forming the second contact hole. As the result, it is possible to prevent the contact resistance between the source region and the source electrode, the contact resistance between the drain region and the drain electrode, the contact resistance between the anode region and the anode electrode, and the contact resistance between the cathode region and the cathode electrode from increasing.

According to the seventh aspect of the present invention, the semiconductor film and the gate insulating film on the gate electrode which is not covered with the channel layer are removed at the time of etching the semiconductor film to form the channel layer. Then, the insulating film is formed so as to cover the insulation substrate together with the channel layer and the gate electrode. In this case, in the thin film transistor and the photodiode, the thickness of the insulating film on the source region and the drain region, the thickness of the insulating film on the anode region and the cathode region, and the thickness of the insulating film on the gate electrode which is not covered with the channel layer become equal to one another. Thus, it is possible to form the first contact holes reaching the surfaces of the source region and drain region, respectively, the second contact hole reaching the surface of the gate electrode, and the third contact holes reaching the surfaces of the anode region and cathode region, respectively, in one step. Therefore, it is possible to simplify the step of forming the contact holes in the semiconductor device.

According to the eighth aspect of the present invention, it is possible to simplify the step of forming the contact holes in the thin film transistor provided in the pixel formation part. Therefore, it is possible to reduce a manufacturing cost for the display by shortening a TAT for the display and decreasing the number of photomasks to be used.

According to the ninth aspect of the present invention, it is possible to simplify the step of forming the contact holes in the semiconductor device provided in the pixel formation part. Therefore, it is possible to reduce a manufacturing cost for the display having the touch panel function by shortening a TAT for the display and decreasing the number of photomasks to be used.

### BRIEF DESCRIPTION OF THE DRAWINGS

Fig. 1 is a plan view that shows a configuration of a TFT according to a first embodiment of the present invention.
Fig. 2(a) is a section view that shows the TFT and is taken along line A-A in Fig. 1, and Fig. 2(b) is a section view that shows the TFT and is taken along line B-B in Fig. 1.
Figs. 3(a) to 3(e) are section views that show steps of fabricating the TFT according to the first embodiment.
Figs. 4(f) to 4(i) are section views that show steps of fabricating the TFT according to the first embodiment.
Fig. 5(a) is a section view that shows a TFT according to a second embodiment of the present invention and is taken along the same line as line A-A in Fig. 1, and Fig. 5(b) is a section view that shows the TFT according to the second embodiment and is taken along the same line as line B-B in Fig. 1.
Figs. 6(a) to 6(f) are section views that show steps of a method for fabricating the TFT according to the second embodiment.
Figs. 7(g) to 7(j) are section views that show steps of the method for fabricating the TFT according to the second embodiment.
Fig. 8 is a plan view that shows a configuration of a semiconductor device according to a third embodiment of the present invention.
Fig. 9 (a) is a section view that shows a TFT and is taken along line C-C in Fig. 8, Fig. 9(b) is a section view that shows the TFT and is taken along line D-D in Fig. 8, and Fig. 9(c) is a section view that shows a photodiode and is taken along line E-E in Fig. 8.
Figs. 10(a) to 10(c) are section views that show steps of fabricating the semiconductor device according to the third embodiment.
Figs. 11(d) to 11(f) are section views that show steps of fabricating the semiconductor device according to the third embodiment.
Figs. 12(g) and 12(h) are section views that show steps of fabricating the semiconductor device according to the third embodiment.
Figs. 13(a) and 13(b) are section views that show a configuration of a double gate type TFT corresponding to a modification example of the TFT according to the first embodiment.
Fig. 14 is a block diagram that shows a configuration of a liquid crystal display corresponding to a first application example.
Fig. 15 is a block diagram that shows a configuration of a liquid crystal display having a touch panel function and corresponding to a second application example.
Fig. 16(a) is a section view that shows shapes of contact holes in a source region and a drain region in a conventional TFT, and Fig. 16(b) is a section view that shows a shape of a contact hole on a gate electrode which is not covered with a channel layer in the conventional TFT.

### EMBODIMENTS OF THE INVENTION

### <1. First Embodiment>

### <1.1 Structure of TFT>

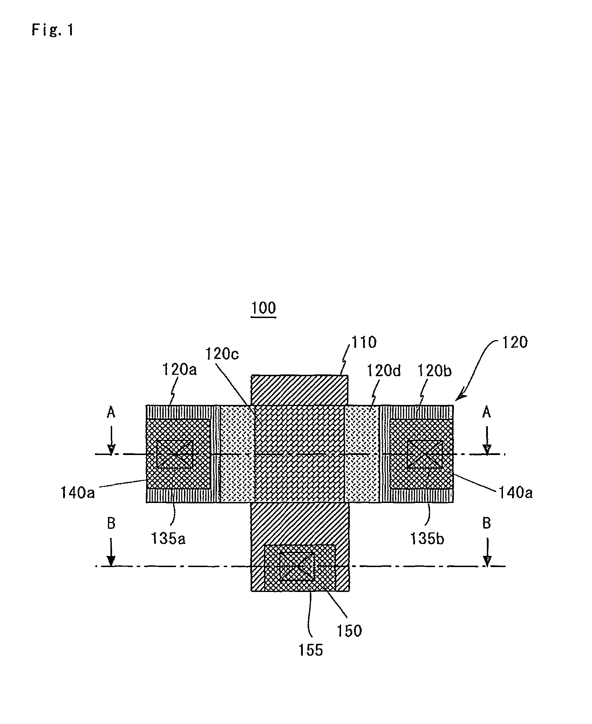

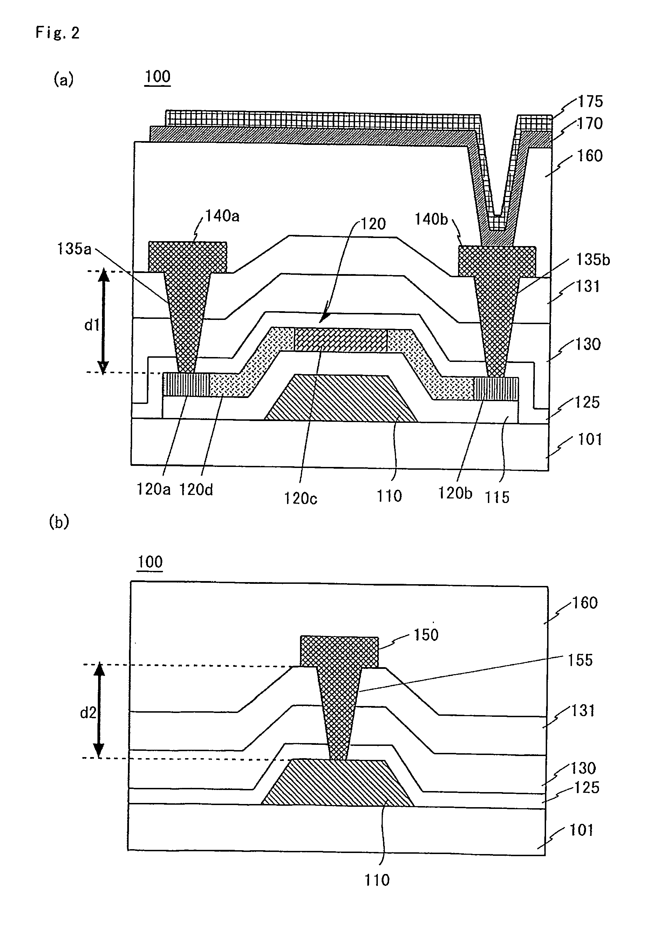

Fig. 1 is a plan view that shows a configuration of a TFT 100 according to a first embodiment of the present invention. Fig. 2(a) is a section view that shows the TFT 100 and is taken along line A-A in Fig. 1. Fig. 2(b) is a section view that shows the TFT 100 and is taken along line B-B in Fig. 1. In order to make Fig. 1 more legible, insulating films such as a gate insulating film, an interlayer insulating film and a planarizing film are not shown in Fig. 1. The TFT 100 is used as a switching element provided in a pixel formation part of a liquid crystal display.

The configuration of the TFT 100 is described with reference to Fig. 1 and Figs. 2(a) and 2(b). As shown in Fig. 1 and Figs. 2(a) and 2(b), a gate electrode 110 made of metal is formed on a glass substrate 101 which is an insulation substrate. A gate insulating film 115 is formed so as to partially cover a surface of the gate electrode 110 and a surface of the glass substrate 101. More specifically, the gate insulating film 115 is formed between a channel layer 120 to be described later and the gate electrode 110 and between the channel layer 120 and the glass substrate 101.

The island-shaped channel layer 120 is formed on a surface of the gate insulating film 115 so as to extend over the gate electrode 110 in a lateral direction when being seen in a plan. The channel layer 120 is made of polycrystalline silicon, and is located above the gate electrode 110. The channel layer 120 includes a channel region 120c which is made of intrinsic silicon doped with no impurities, two LDD (Lightly Doped Drain) regions 120d which are formed with the channel region 120c interposed in between and each of which corresponds to a low-concentration silicon region (an n⁻ region) doped with a low concentration of n-type impurities, and a source region 120a and a drain region 120b which are located outside the LDD regions 120d, respectively, and each of which corresponds to a high-concentration silicon region (an n⁺ region) doped with a high concentration of n-type impurities.

A cap film 125, which is an insulating film, is formed so as to entirely cover the glass substrate 101 together with the channel layer 120 and the gate electrode 110. A first interlayer insulating film 130 and a second interlayer insulating film 131 are laminated sequentially on a surface of the cap film 125. As the result, only the cap film 125, the first interlayer insulating film 130 and the second interlayer insulating film 131 are laminated, but the gate insulating film 115 is not laminated on each of the source region 120a, the drain region 120b, and a gate contact region of the gate electrode 110. Accordingly, contact holes 135a and 135b formed on the source region 120a and the drain region 120b, respectively, and a contact hole 155 formed on the gate contact region are formed by etching the cap film 125, the first interlayer insulating film 130 and the second interlayer insulating film 131.

Further, a source electrode 140a connected electrically to the source region 120a via the contact hole 135a, a drain electrode 140b connected electrically to the drain region 120b via the contact hole 135b, and a wiring layer 150 connected electrically to the gate contact region of the gate electrode 110 via the contact hole 155 are formed on a surface of the second interlayer insulating film 131. The source electrode 140a, the drain electrode 140b and the wiring layer 150 are made of the same metal. A planarizing film 160 is formed so as to entirely cover the second interlayer insulating film 131 together with the source electrode 140a, the drain electrode 140b and the wiring layer 150. A pixel electrode 170 made of transparent metal and connected electrically to the drain electrode 140b is formed on a surface of the planarizing film 160. A light shielding layer 175 is formed on a surface of the pixel electrode 170.

### <1.2 Method for Fabricating TFT>

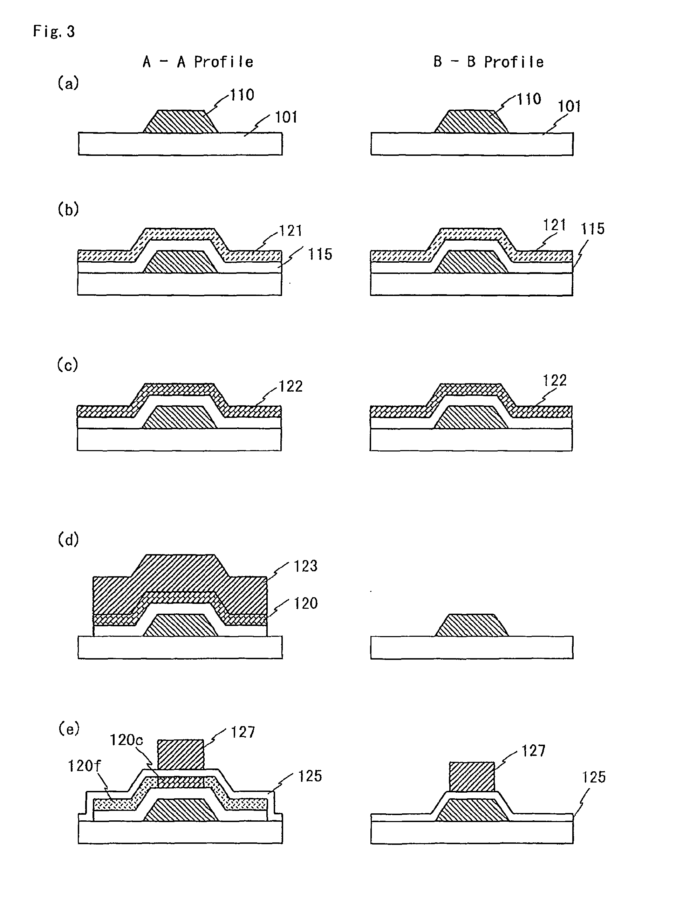

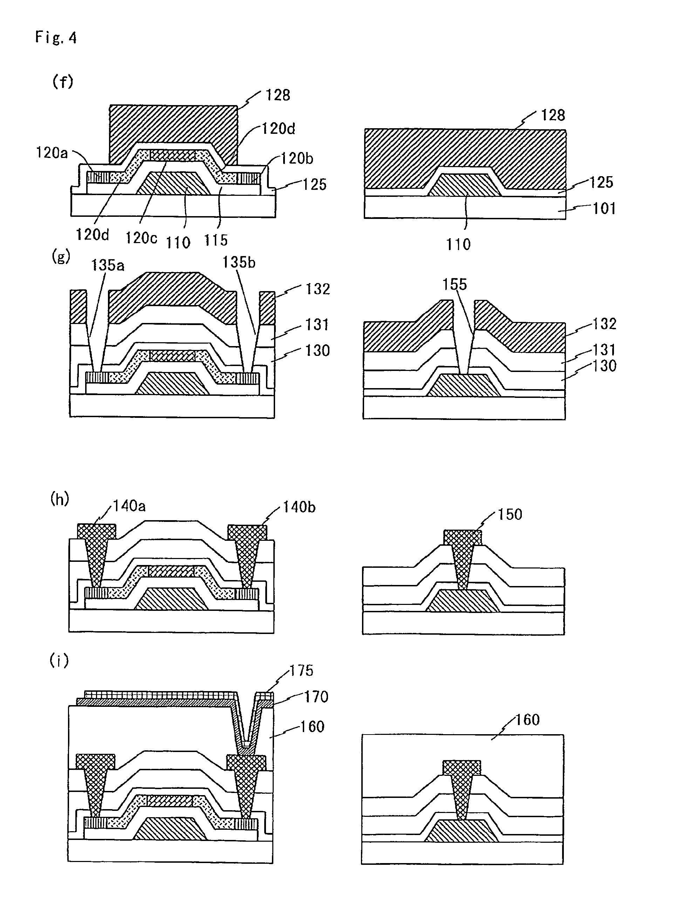

Figs. 3(a) to 3(e) and Figs. 4(f) to 4(i) are section views that show steps of fabricating the TFT 100 according to the first embodiment. In the respective drawings, the left corresponds to the section view taken along line A-A in Fig. 1 and the right corresponds to the section view taken along line B-B in Fig. 1.

The method for fabricating the TFT 100 is described with reference to Figs. 3(a) to 3(e) and Figs. 4(f) to 4(i). First, a metal film (not shown) having a thickness of 50 to 200 nm and mainly containing molybdenum (Mo) is formed by sputtering on a glass substrate 101. Herein, a metal film mainly containing aluminum (Al), tungsten (W), tantalum (Ta), copper (Cu), chromium (Cr) or the like or a metal film made of an alloy thereof may be formed instead of the metal film mainly containing molybdenum. Moreover, the metal film may be a single-layer film which is one of the metal films described above, or a laminated metal film obtained by lamination of metal films selected appropriately from the metal films described above. A resist pattern (not shown) is formed by photolithography on the metal film. As shown in Fig. 3(a), the metal film is subjected to dry etching with the resist pattern used as a mask to form a gate electrode 110 and a gate wire (not shown). Herein, the metal film may be subjected to wet etching.

As shown in Fig. 3(b), a gate insulating film 115 is formed by plasma enhanced chemical vapor deposition (hereinafter, referred to as "plasma CVD") so as to entirely cover the glass substrate 101 together with the gate electrode 110. Further, an amorphous silicon film 121 is formed successively on a surface of the gate insulating film 115 by change of a raw material gas. The gate insulating film 115 has a thickness of 50 to 300 nm, and the amorphous silicon film 121 has a thickness of 50 to 100 nm. The gate insulating film 151 is made of silicon nitride (SiNₓ), for example, and is formed using a monosilane (SiH₄) gas, an ammonium (NH₃) gas and a nitrogen monoxide (N₂O) gas. Moreover, the gate insulating film 151 may be an insulating film made of one of TEOS (Tetra Ethoxy Silane: Si(OC₂H₅)₄), silicon oxide (SiO₂) and silicon oxynitride (SiON) instead of silicon nitride, or may be a laminated insulating film obtained by lamination of insulating films selected appropriately from the these insulating films. Moreover, the amorphous silicon film 121 is formed using a monosilane gas and a hydrogen (H₂) gas.

In the case of successively forming the gate insulating film 115 and the amorphous silicon layer 121, immediately after the formation of the gate insulating film 115, the amorphous silicon layer 121 is formed in the state that the surface of the gate insulating film 115 is not exposed to the atmosphere. For this reason, it is possible to prevent an interface between the gate insulating film 115 and the amorphous silicon film 121 from being contaminated. Thus, it is possible to suppress variations in a threshold voltage at the TFT 100.

Next, the amorphous silicon film 121 is subjected to annealing for about 1 to 2 hours in an atmosphere of nitrogen at 400 to 600°C such that hydrogen is desorbed previously from the amorphous silicon film 121. As shown in Fig. 3(c), then, the amorphous silicon layer 121 from which hydrogen is desorbed by the annealing is subjected to laser irradiation to crystallize the amorphous silicon film 121, so that a polycrystalline silicon film 122 is obtained. In order to crystallize the amorphous silicon film 121, an excimer laser such as a xenon chloride (XeCl) excimer laser or a krypton fluoride (KrF) excimer laser is used. Herein, a continuous wave laser may be used instead of the excimer laser.

As shown in Fig. 3(d), a resist pattern 123 is formed by photolithography so as to extend over the gate electrode 110 in a lateral direction. At this time, the resist pattern 123 is not formed on a gate contact region. The polycrystalline silicon film 122 is subjected to dry etching with the resist pattern 123 used as a mask to form an island-shaped channel layer 120. Further, the gate insulating film 115 is subjected to etching with the resist pattern 123 used as a mask by change of an etching gas. Thus, the gate insulating film 115 is left only below the channel layer 120, and is removed from the gate contact region of the gate electrode 110. As the result, a surface of the gate contact region is bared as a surface of the channel layer 120.

The resist pattern 123 is stripped by ashing using an oxygen (O₂) gas. As shown in Fig. 3(e), then, a cap film 125 is formed by plasma CVD so as to entirely cover the glass substrate 101 together with the gate electrode 110 and the channel layer 120. The cap film 125 is made of silicon oxide and the like, and has a thickness of several nanometers to 100 nm. Next, ion implantation or ion doping is performed for the control of a threshold voltage at the TFT 100, so that the entire channel layer 120 is doped with n-type impurities such as phosphorus (P) or p-type impurities such as boron (B) from above the cap film 125 (hereinafter, referred to as "channel doping").

A resist film (not shown) is formed on the cap film 125. Next, the resist film is irradiated with exposure light from below the glass substrate 101 (a lower side in Fig. 3(e)). Since the gate electrode 110 functions as a photomask for shielding exposure light, a resist pattern 127 is formed in a self-aligned manner with respect to the gate electrode 110. Ion implantation or ion doping is performed with the resist pattern 127 used as a mask from above the cap film 125, so that the channel layer 120 is doped with a low concentration of phosphorus. In the channel layer 120, thus, an n⁻ region 120f is formed in a region where phosphorus is implanted, and a channel region 120c is formed in a region interposed between two n⁻ regions 120f. Thereafter, the resist pattern 127 is stripped.

As shown in Fig. 4(f), a resist pattern 128, which is longer than the resist pattern 127 in the lateral direction, is formed by photolithography on the cap film 125 at a position above the gate electrode 110. Next, ion implantation or ion doping is performed with the resist pattern 128 used as a mask from above the cap film 125, so that the channel layer 120 is doped with a high concentration of phosphorus. Thus, n⁺ regions serving as a source region 120a and a drain region 120b are formed at two end portions of the n⁻ regions 120f, respectively. Moreover, each of the n⁻ region 120f interposed between the source region 120a and the channel region 120c and the n⁻ region 120f interposed between the drain region 120b and the channel region 120c serves as an LDD region 120d. Next, activation annealing is performed for activation of phosphorus contained by doping in the source region 120a, the drain region 120b and the LDD region 120d.

As shown in Fig. 4(g), a first interlayer insulating film 130 and a second interlayer insulating film 131 are laminated sequentially by plasma CVD, low pressure CVD or the like on a surface of the cap film 125. The first interlayer insulating film 130 is made of silicon nitride and has a thickness of 50 to 400 nm. The second interlayer insulating film 131 is made of one of TEOS, silicon oxide and silicon oxynitride, and has a thickness of 100 to 700 nm. Further, the glass substrate 101 is subjected to annealing (hydrogenation annealing) for about 1 to 2 hours in an atmosphere of nitrogen gas at 300 to 500°C, so that hydrogen in the first interlayer insulating film 130 is dispersed in the channel layer 120. Thus, a dungling bond of a silicon atom in the channel layer 120 is terminated by hydrogen, so that an interface state hardly occurs at an interface between the channel layer 120 and the gate insulating film 115 and an interface between the channel layer 120 and the first interlayer insulating film 130. This leads to improvement of characteristics such as the threshold voltage at the TFT 100. Herein, the activation annealing can be omitted on such condition that the hydrogenation annealing also brings about the result of the activation annealing. For this reason, it is possible to further simplify the fabricating process of the TFT 100.

Next, a resist pattern 132 is formed by photolithography on the second interlayer insulating film 131. Then, the second interlayer insulating film 131, the first interlayer insulating film 130 and the cap film 125 are subjected to dry etching sequentially with the resist pattern 132 used as a mask to form contact holes 135a, 135b and 155 reaching the source region 120a, the drain region 120b and the gate contact region, respectively. At this time, since the gate insulating film 115 on the gate contact region is removed previously in the step shown in Fig. 3(d). For this reason, the insulating film on the gate contact region becomes equal in thickness to the insulating film on the source region 120a and the drain region 120b. Therefore, the contact holes 135a and 135b reaching surfaces of the source region 120a and drain region 120b, respectively, and the contact hole 155 reaching the surface of the gate contact region can be formed simultaneously in such a manner that the second interlayer insulating film 131, the first interlayer insulating film 130 and the cap film 125 are subjected to etching sequentially on the source region 120a, the drain region 120b and the gate contact region.

An aluminum film (not shown) is formed by sputtering on a surface of the second interlayer insulating film 131 and the contact holes 135a, 135b and 155. As shown in Fig. 4(h), next, a resist pattern (not shown) is formed by photolithography on the aluminum film, and the aluminum film is subjected to dry etching with the resist pattern used as a mask. As the result, a source electrode 140a connected electrically to the source region 120a, a drain electrode 140b connected electrically to the drain region 120b, and a wiring layer 150 connected electrically to the gate contact region of the gate electrode 110 are formed. Herein, the aluminum film may be subjected to wet etching. Moreover, a metal film mainly containing titanium or molybdenum or a laminated metal film obtained by lamination of films selected appropriately from an aluminum film, a titanium film and a molybdenum film may be used instead of the aluminum film. The TFT 100 is fabricated as described above.

In order to use the TFT 100 as a switching element provided in a pixel formation part of a liquid crystal display, it is required to further carry out the following steps. As shown in Fig. 4(i), a planarizing film 160 made of photosensitive acrylic resin is formed on the surface of the second interlayer insulating film 131, and a contact hole reaching the drain electrode 140b is formed by exposure and development of the planarizing film 160. Next, a transparent metal film (not shown) made of ITO (Indium Tin Oxide) is formed by sputtering on a surface of the planarizing film 160 and in the contact hole. The transparent metal film is subjected to patterning to form a pixel electrode 170 connected electrically to the drain electrode 140b via the contact hole. Further, a light shielding layer 175 made of chromium or the like is formed on a surface of the pixel electrode 170 in the TFT 100.

### <1.3 Effects>

It is apparent from the foregoing description that the cap film 125, the first interlayer insulating film 130 and the second interlayer insulating film 131 are formed on each of the source region 120a, the drain region 120b, and the gate contact region of the gate electrode 110. Thus, the thickness d1 of the insulating film on the source region 120a and the drain region 120b becomes equal to the thickness d2 of the insulating film on the gate electrode 110 which is not covered with the channel layer 120. Therefore, it is possible to simultaneously form the contact holes 135a and 135b reaching the surfaces of the source region 120a and drain region 120b, respectively, and the contact hole 155 reaching the surface of the gate electrode 110 in one step, and to simplify the step of forming the contact holes in the TFT 100. As the result, it is possible to improve a yield because of the shortening of a TAT (Turn Around Time) for the TFT 100 and to reduce a fabricating cost because of the decrease of the number of photomasks.

Moreover, the contact hole 135a formed on the source region 120a, the contact hole 135b formed on the drain region 120b, and the contact hole 155 formed on the gate electrode 110 which is not covered with the channel layer 120 become equal in depth to one another. Thus, at the time of forming the contact hole 155, there is no possibility that the source region 120a in the contact hole 135a and the drain region 120b in the contact hole 135b are thinned excessively or removed entirely. As the result, it is possible to prevent contact resistance between the source region 120a and the source electrode 140a and contact resistance between the drain region 120b and the drain electrode 140b from increasing.

### <2. Second Embodiment>

### <2.1 Configuration of TFT>

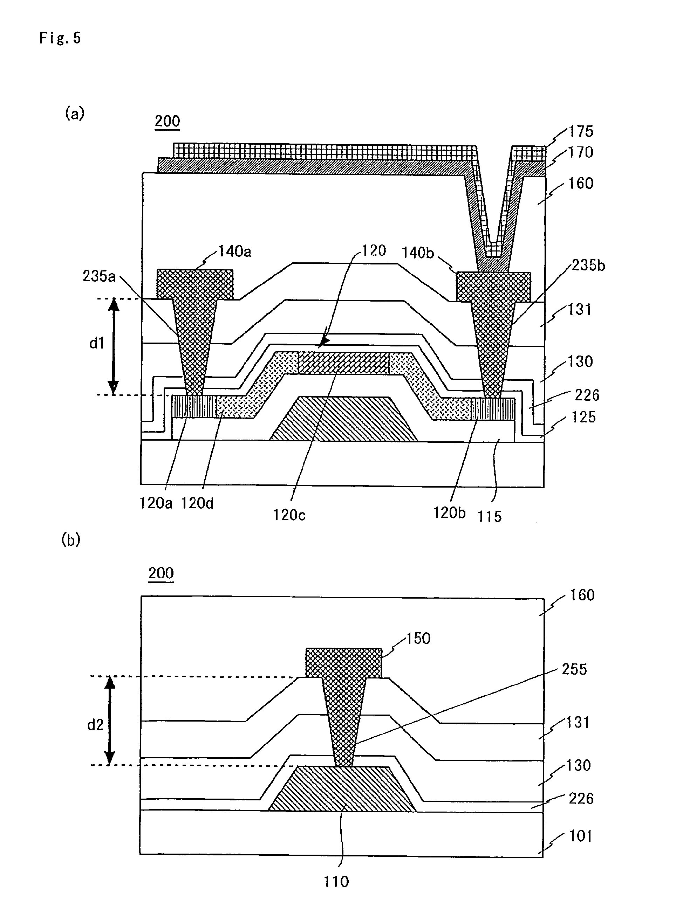

A plan view that shows a TFT 200 according to a second embodiment is identical with Fig. 1 which is the plan view showing the TFT 100 according to the first embodiment, and therefore is not prepared here. Fig. 5 (a) is a section view that shows the TFT 200 and is taken along the same line as line A-A in Fig. 1. Fig. 5(b) is a section view that shows the TFT 200 and is taken along the same line as line B-B in Fig. 1. In Figs. 5(a) and 5(b), identical constituent elements with those of the TFT 100 shown in Figs. 2(a) and 2(b) are denoted with identical reference symbols with those shown in Figs. 2 (a) and 2 (b), and the description thereof is not given here.

As shown in Figs. 5(a) and 5(b), the TFT 200 is different from the TFT 100 in the following point. That is, a passivation film 226 is formed on a surface of a cap film 125 which is formed on a source region 120a and a drain region 120b. As shown in Fig. 5(b), however, the cap film 125 is not formed, but only the passivation film 226 is formed on a gate contact region of a gate electrode 110 which is not covered with a channel layer 120. As will be described later, the cap film 125 is considerably smaller in thickness than first and second interlayer insulating films 130 and 131. Therefore, a thickness d1 of an insulating film on the source region 120a and the drain region 120b is substantially equal to a thickness d2 of that on the gate contact region of the gate electrode 110. As the result, contact holes 235a and 235b to be formed on the source region 120a and the drain region 120b, respectively, becomes almost equal in depth to a contact hole 255 to be formed on the gate contact region.

### <2.2 Method for Fabricating TFT>

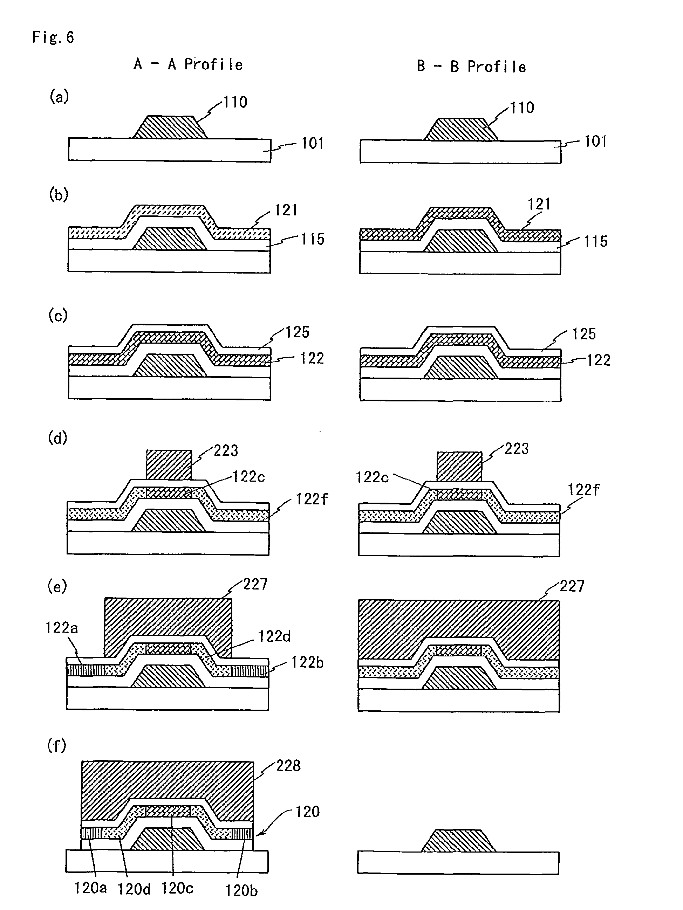

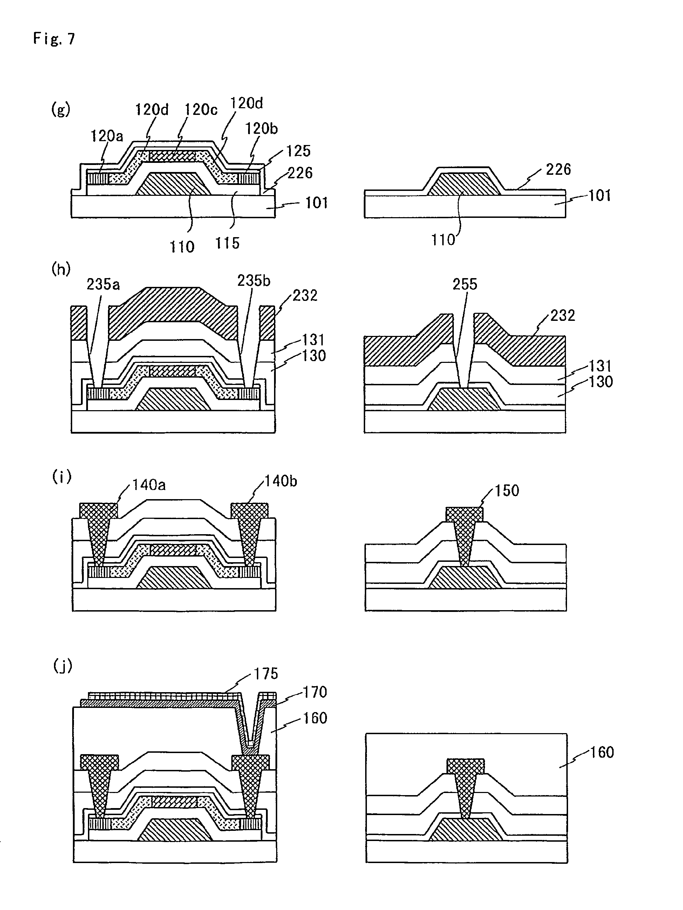

Figs. 6(a) to 6(f) and Figs. 7(g) to 7(j) are section views that show steps of a method for fabricating the TFT 200 according to the second embodiment. In the respective drawings, the left corresponds to the section view taken along the same line as line A-A in Fig. 1, and the right corresponds to the section view taken along the same line as line B-B in Fig. 1. Moreover, the fabricating method in this embodiment is different from the fabricating method in the first embodiment only in the sequence of a step of removing a gate insulating film 115 on a gate contact region. Therefore, almost the steps of the fabricating method in this embodiment are identical with those of the fabricating method in the first embodiment. In the following, the identical steps with those in the first embodiment will be described briefly, and the different steps from those in the first embodiment will be described in detail.

As shown in Fig. 6(a), a gate electrode 110 is formed on a glass substrate 101. As shown in Fig. 6(b), next, a gate insulating film 115 and an amorphous silicon film 121 are formed successively so as to entirely cover the glass substrate 101 together with the gate electrode 110.

As shown in Fig. 6(c), the amorphous silicon film 121 is subjected to laser irradiation from above. Thus, the amorphous silicon film 121 is crystallized, so that a polycrystalline silicon film 122 is obtained. Next, a considerably thin cap film 125, which is made of silicon oxide and has a thickness of several nanometers, is formed on a surface of the polycrystalline silicon film 122. Next, the entire polycrystalline silicon film 122 is subjected to channel doping in order to adjust a threshold voltage at the TFT 200.

As shown in Fig. 6(d), a resist film (not shown) formed on a surface of the cap film 125 is irradiated with exposure light from below the glass substrate 101 with the gate electrode 110 used as a mask to form a resist pattern 223 formed in a self-aligned manner with respect to the gate electrode 110. The polycrystalline silicon film 122 is doped with a low concentration of phosphorus with the resist pattern 223 used as a mask to form an n⁻ region 122f, and then the resist pattern 223 is stripped.

As shown in Fig. 6(e), a resist pattern 227, which is longer than the resist pattern 223 in a lateral direction, is formed by photolithography on the surface of the cap film 125 at a position above the gate electrode 110. Next, two end portions of the polycrystalline silicon film 122 are doped with a high concentration of phosphorus from above the cap film 125 with the resist pattern 227 as a mask to form n⁺ regions 122a and 122b, respectively. Herein, the n⁻ region 122f, which is not doped with phosphorus, serves as an n⁻ region 122d. Thereafter, the resist pattern 227 is stripped. Further, activation annealing is performed for activation of phosphorus contained by doping in the n⁻ region 122d and the n⁺ regions 122a and 122b.

As shown in Fig. 6(f), a resist pattern 228, which extends over the gate electrode 110 and is longer than the resist pattern 227 in the lateral direction, is formed by photolithography on the surface of the cap film 125 at the position above the gate electrode 110. The cap film 125 is subjected to dry etching with the resist pattern 228 used as a mask, and then the polycrystalline silicon film 122 is subjected to etching to form a channel layer 120. Further, the gate insulating film 115 is subjected to etching with the resist pattern 228 used as a mask. On the other hand, since the resist pattern 228 is not formed on the gate contact region of the gate electrode 110, all the cap film 125, the polycrystalline silicon film 122 and the gate insulating film 115 on the gate contact region are removed, so that a surface of the gate contact region is bared. As the result, the gate insulating film 115 is left only below the channel layer 120.

Unlike the first embodiment, according to this embodiment, the n⁻ region 122d and the n⁺ regions 122a and 122b are formed in the polycrystalline silicon film 122, and then the polycrystalline silicon film 122 is subjected to patterning to form the channel layer 120. As the result, the n⁺ region 122a serves as a source region 120a, the n⁺ region 122b serves as a drain region 120b, and the n⁻ region 122d serves as an LDD region 120d.

As shown in Fig. 7(g), a passivation film 226, which is made of silicon oxide and has a thickness of 50 to 100 nm, is formed on the surface of the cap film 125. At this time, since the cap film 125 on the gate contact region is removed, the passivation film 225 is formed on a surface of the gate electrode 110 in the gate contact region. The cap film 125 is already formed on a surface of the channel layer 120, but has a considerably thin thickness of several nanometers. Therefore, a total thickness of the cap film 125 and the passivation film 225 on the channel layer 120 is substantially equal to a thickness of the passivation film 226 on the gate contact region.

As shown in Fig. 7(h), a first interlayer insulating film 130 and a second interlayer insulating film 131 are formed successively and entirely on a surface of the passivation film 226 together with the channel layer 120 and the gate contact region, and hydrogenation annealing is performed for terminating a dungling bond of a silicon atom in the channel layer 120. Further, the second interlayer insulating film 131, the first interlayer insulating film 130 and the passivation film 226 are subjected to etching successively with the resist pattern 232 used as a mask. As the result, a contact hole 235a reaching a surface of the source region 120a, a contact hole 235b reaching a surface of the drain region 120b, and a contact hole 255 reaching the surface of the gate contact region are formed simultaneously. Thereafter, the resist pattern 232 is stripped. Herein, the cap film 125 is formed on the surfaces of the source region 120a and drain region 120b, but has the considerable small thickness of several nanometers. Therefore, when the passivation film 226 is subjected to etching, the cap film 125 is removed together with the passivation film 226.

As shown in Fig. 7(i), a metal film (not shown) made of aluminum or the like is formed by sputtering on the second interlayer insulating film 131 and in the contact holes 235a, 235b and 255. Then, the metal film is subjected to patterning to form a source electrode 140a, a drain electrode 140b and a wiring layer 150.

As shown in Fig. 7(j), a planarizing film 160 is formed on a surface of the second interlayer insulating film 131 together with the source electrode 140a, the drain electrode 140b and the wiring layer 150. Next, a pixel electrode 170 connected electrically to the drain electrode 140b is formed on the planarizing film 160, and a light shielding layer 175 is formed on a surface of the pixel electrode 170. The TFT 200 is fabricated as described above.

### <2.3 Effects>

It is apparent from the foregoing description that since effects of the TFT 200 according to this embodiment and the method for fabricating the same are identical with those of the TFT 100 according to the first embodiment and the method for fabricating the same, the description thereof is not given here.

### <3. Third Embodiment>

### <3.1 Configuration of Semiconductor Device>

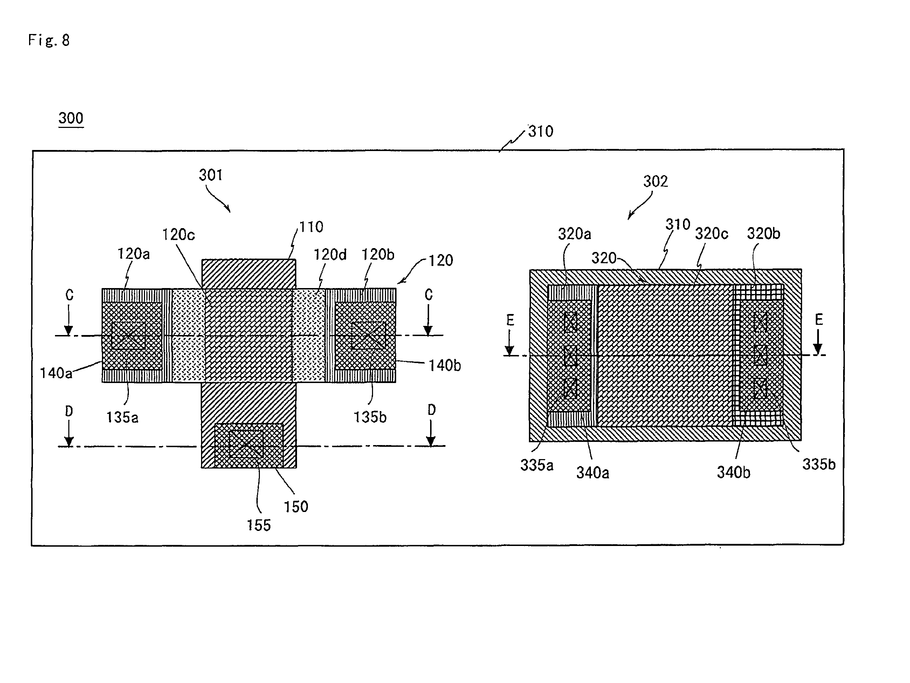

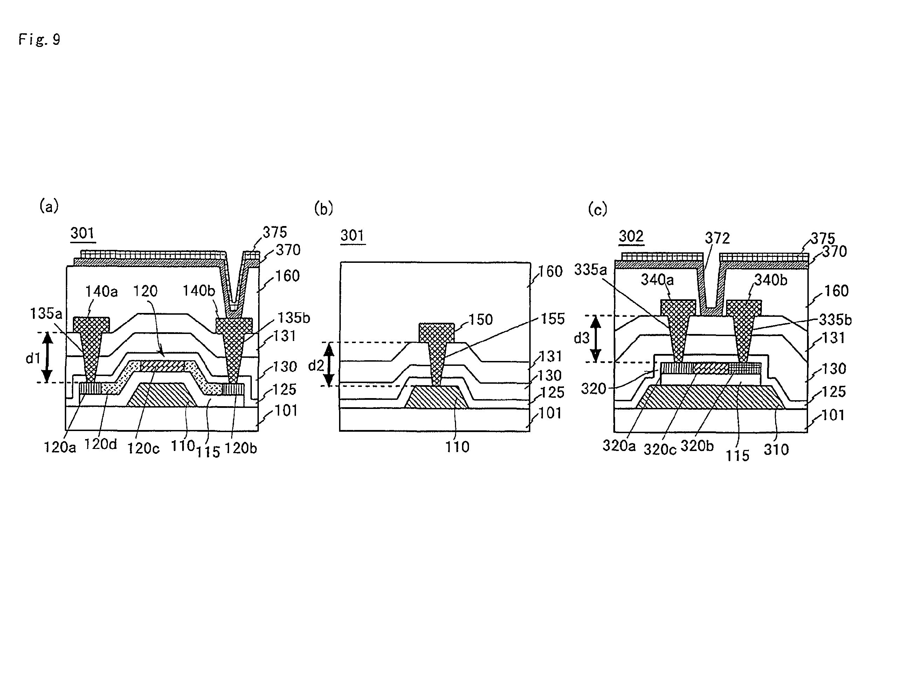

A semiconductor device 300 in which a TFT 301 having a bottom gate structure and a photodiode 302 having a light shielding film are formed on one glass substrate 101 is described in this embodiment. Fig. 8 is a plan view that shows a configuration of the semiconductor device 300 according to the third embodiment of the present invention. Fig. 9 (a) is a section view that shows the TFT 301 and is taken along line C-C in Fig. 8. Fig. 9(b) is a section view that shows the TFT 301 and is taken along line D-D in Fig. 8. Fig. 9(c) is a section view that shows the photodiode 302 and is taken along line E-E in Fig. 8. In order to make Fig. 8 more legible, insulating films such as a gate insulating film, an interlayer insulating film and a planarizing film are not shown in Fig. 8.

The TFT 301 which is included in the semiconductor device 300 and has the bottom gate structure is identical in configuration with the TFT 100 shown in Fig. 1 and Figs. 2(a) and 2(b). For this reason, constituent elements of the TFT 301 are denoted with the same reference symbols as constituent elements of the TFT 301 shown in Fig. 8 and Figs. 9(a) and 9(b), and the description thereof is not given here. In the following, a configuration of the photodiode 302 will be described. A light shielding film 310 is formed on the glass substrate 101. The light shielding film 310 is formed on the glass substrate 101 in order to prevent light emitted from a backlight source (not shown) from being incident into the photodiode 302, and is identical in material and thickness with the gate electrode 110 of the TFT 301.

An island-shaped silicon layer 320 is formed above the light shielding film 310 with a gate insulating film 115 interposed in between so as not to protrude from the light shielding film 310. The island-shaped silicon layer 320 is made of polycrystalline silicon obtained by crystallization of amorphous silicon, as in the channel layer 120 of the TFT 301.

The island-shaped silicon layer 320 includes a cathode region 320a serving as an n⁺ region formed at a left end portion of the island-shaped silicon layer 320 and doped with a high concentration of phosphorus, an anode region 320b serving as a p⁺ region formed at a right end portion of the island-shaped silicon layer 320 and doped with a high concentration of boron, and an intrinsic region 320c interposed between the cathode region 320a and the anode region 320b and doped with no impurities. The photodiode 302 has a lateral PIN structure that the intrinsic region 320c is formed between the anode region 320b and the cathode region 320a, is excellent in quantum efficiency, and allows high-speed response. In the photodiode 302 having the lateral type PIN structure, the cathode region 320a, the intrinsic region 320c and the anode region 320b are collectively referred to as an island-shaped semiconductor layer in some instances. Herein, a PN junction diode in which a p-type region and an n-type region are joined directly may be used instead of the photodiode 302.

A cap film 125 made of silicon oxide is formed on a surface of the island-shaped silicon layer 320. Further, a first interlayer insulating film 130 made of silicon nitride and a second interlayer insulating film 131 made of silicon oxide are laminated sequentially on the cap film 125.

A contact hole 335a reaching a surface of the cathode region 320a and a contact hole 335b reaching a surface of the anode region 320b are formed so as to penetrate through the first and second interlayer insulating films 130 and 131 and the cap film 125. A cathode electrode 340a and an anode electrode 340b are formed on a surface of the second interlayer insulating film 131. The cathode electrode 340a is connected electrically to the cathode region 320a via the contact hole 335a, and the anode electrode 340b is connected electrically to the anode region 320b via the contact hole 335b.

A planarizing film 160 made of photosensitive acrylic resin is formed on the surface of the second interlayer insulating film 131 together with the cathode electrode 340a and the anode electrode 340b. In order to detect light reflected from a finger or the like with reliability, a recessed portion 372 is formed in the planarizing film 160 at a position above the intrinsic region 320c of the island-shaped silicon layer 320 so as to reach the surface of the second interlayer insulating film 131. A pixel electrode 370 made of transparent metal such as ITO is formed on the planarizing film 160. The pixel electrode 370 is formed from a surface of the planarizing film 160 at a position above the cathode electrode 340a to the surface of the planarizing film 160 at a position above the anode electrode 340b so as to cover the inside of the recessed portion 372. Further, a light shielding layer 375 is formed on a surface of the pixel electrode 370 at a position above the cathode electrode 340a and the anode electrode 340b.

### <3.2 Method for Fabricating Semiconductor Device>

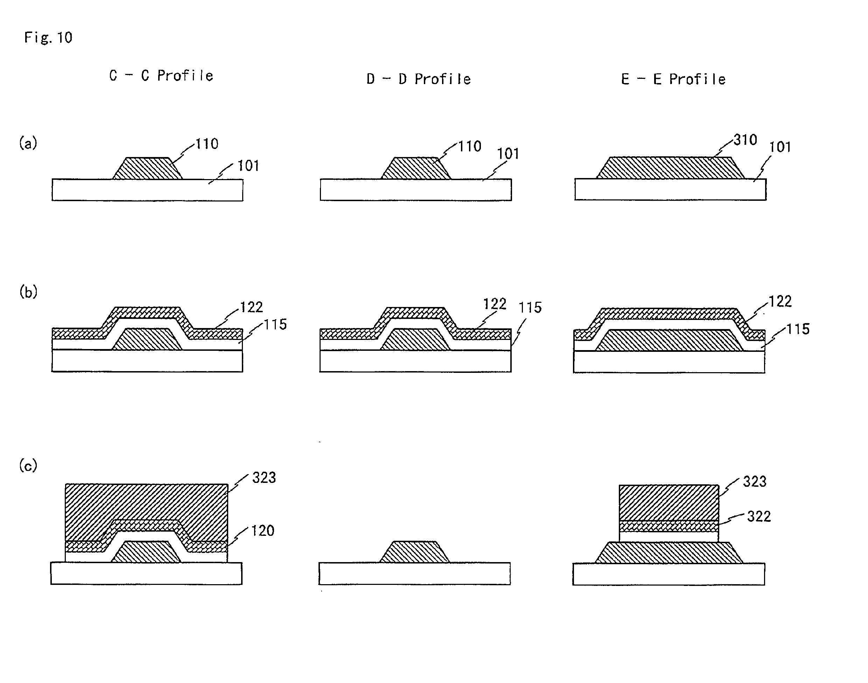

Figs. 10(a) to 10(c), Figs. 11(d) to 11(f) and Figs. 12(g) and 12(h) are section views that show steps of fabricating the semiconductor device 300 according to the third embodiment. In Figs. 10(a) to 10(c), Figs. 11(d) to 11(f) and Figs. 12(g) and 12(h), the left corresponds to the section view that shows the TFT 301 and is taken along line C-C in Fig. 8, the center corresponds to the section view that shows the TFT 301 and is taken along line D-D in Fig. 8, and the right corresponds to the section view that shows the photodiode 302 and is taken along line E-E in Fig. 8. Moreover, a method for fabricating the TFT 301 is identical with the method for fabricating the TFT 100 described in the first embodiment. For this reason, the constituent elements of the TFT 301 are denoted with the same reference symbols as those of the constituent elements of the TFT 100, and the description thereof will be given briefly. In the following, a method for fabricating the photodiode 302 will be described mainly. Herein, each constituent element that forms the photodiode 302 is identical in material and thickness with the corresponding constituent element of the TFT 301. Since the material for and the thickness of each constituent element of the TFT 301 have been described in detail in the fabricating method described in the first embodiment, the description thereof is not given here.

As shown in Fig. 10(a), a metal layer (not shown) formed by sputtering on a glass substrate 101 is subjected to etching to form a gate electrode 110 of the TFT 301 and a light shielding film 310 of the photodiode 302.

As shown in Fig. 10(b), a gate insulating film 115 and an amorphous silicon film (not shown) are formed successively by plasma CVD so as to entirely cover the glass substrate 101 together with the gate electrode 110 of the TFT 301 and the light shielding film 310 of the photodiode 302. Next, the amorphous silicon film is subjected to annealing for about 1 to 2 hours in an atmosphere of nitrogen at about 400°C such that hydrogen is desorbed previously from the amorphous silicon film. Then, the amorphous silicon film from which hydrogen is desorbed is subjected to laser irradiation using an excimer laser or a continuous wave laser. Thus, the amorphous silicon film is crystallized, so that a polycrystalline silicon film 122 is obtained.

As shown in Fig. 10(c), a resist pattern 323 is formed by photolithography on the polycrystalline silicon film 122. The polycrystalline silicon film 122 is subjected to dry etching with the resist pattern 323 used as a mask. Further, the gate insulating film 115 is subjected to etching with the resist pattern 323 used as a mask. As the result, in the TFT 301, a channel layer 120 made of polycrystalline silicon is formed so as to extend over the gate electrode 110 in a lateral direction, and the gate insulating film 115 is left only below the channel layer 120. The polycrystalline silicon film 122 and the gate insulating film 115 are removed from a gate contact region of a gate electrode 110, so that the gate contact region is bared. On the other hand, in the photodiode 302, an island-shaped silicon layer 320 is formed above the light shielding film 310 with the gate insulating film 115 interposed in between, and the gate insulating film 115 is left only below the island-shaped silicon layer 320.

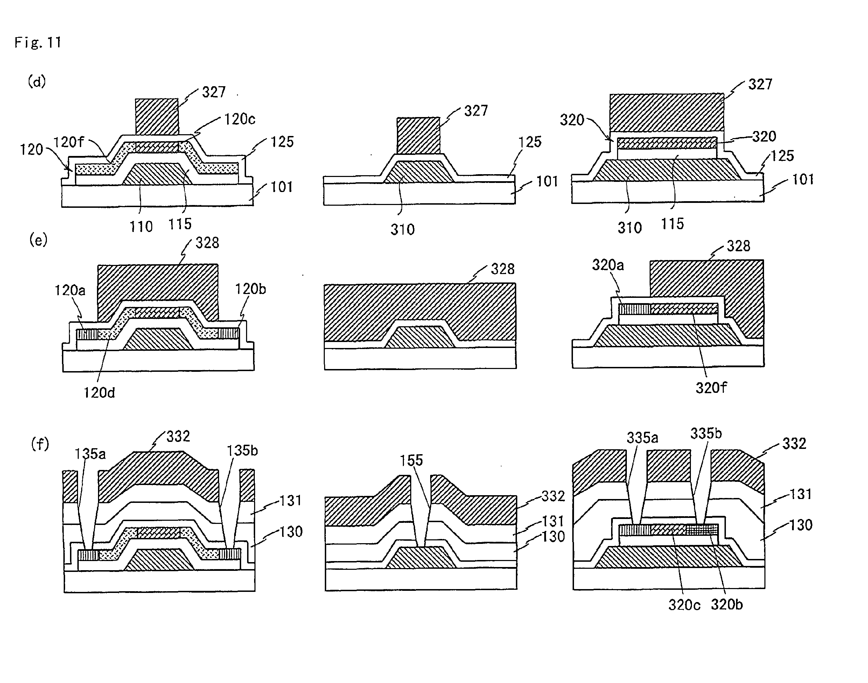

As shown in Fig. 11(d), a cap film 125 is formed by plasma CVD so as to entirely cover the glass substrate 101 together with the channel layer 120 and the island-shaped silicon layer 320, and the channel layer 120 is subjected to channel doping from above the cap film 125 in order to control a threshold voltage at the TFT 301. Next, a resist film (not shown) is formed on the cap film 125, and the resist film is irradiated with exposure light from below the glass substrate 101. Since each of the gate electrode 110 and the light shielding film 310 functions as a photomask for shielding exposure light, a resist pattern 327 is formed in a self-aligned manner with respect to the gate electrode 110 and the light shielding film 310. The channel layer 120 is doped by ion implantation or ion doping with a low concentration of phosphorus from above the cap film 125 with the resist pattern 327 used as a mask, so that an n⁻ region 120f is formed in the channel layer 120. At this time, the gate contact region on the gate electrode 110 and the island-shaped silicon layer 320 of the photodiode 302 are covered with the resist pattern. Therefore, the island-shaped silicon layer 320 is not doped with phosphorus. Thereafter, the resist pattern 327 is stripped.

As shown in Fig. 11(e), a resist pattern 328 is formed by photolithography on the cap film 125. The resist pattern 328 is longer than the resist pattern 327 in the lateral direction, and is formed above a region serving as an intrinsic region 320c and a region serving as an anode region 320b in the island-shaped silicon layer 320 of the photodiode 302. Next, the channel layer 120 and the island-shaped silicon layer 320 are doped by ion implantation or ion doping with a high concentration of phosphorus with the resist pattern 328 used as a mask, so that n⁺ regions are formed in the channel layer 120 and the island-shaped silicon layer 320, respectively. The two n⁺ regions formed in the TFT 301 serve as a source region 120a and a drain region 120b, respectively, each of the two n⁻ regions 120f interposed between the source region 120a and the drain region 120b serves as an LDD region 120d, and the intrinsic region interposed between the two LDD regions 120d serves as a channel region 120c. On the other hand, the n⁺ region formed in the island-shaped silicon layer 320 of the photodiode 302 serves as a cathode region 320a.

As in the cases shown in Figs. 11(d) and 11(e), further, a p⁺ region doped with a high concentration of boron is formed in the island-shaped silicon layer 320 of the photodiode 302. The P⁺ region serves as an anode region 320b, and a region interposed between the cathode region 320a and the anode region 320b serves as an intrinsic region 320c. Thereafter, activation annealing is performed for activation of the impurities contained by doping in each of the TFT 301 and the photodiode 302.

A first interlayer insulating film 130 and a second interlayer insulating film 131 are laminated sequentially by plasma CVD, low pressure CVD or the like on a surface of the cap film 125. Next, hydrogen contained in the first interlayer insulating film 130 is dispersed by hydrogenation annealing into the channel layer 120 and the island-shaped silicon layer 320 to terminate a dungling bond of a silicon atom contained in each of the channel layer 120 and the island-shaped silicon layer 320.

As shown in Fig. 11(f), a resist pattern 332 is formed by photolithography, and the second interlayer insulating film 131, the first interlayer insulating film 130 and the cap film 125 are subjected to dry etching sequentially with the resist pattern 332 used as a mask. As the result, in the TFT 301 and the photodiode 302, a contact hole 135a reaching a surface of the source region 120a, a contact hole 135b reaching a surface of the drain region 120b, a contact hole 155 reaching a surface of the gate contact region, a contact hole 335a reaching a surface of the cathode region 320a, and a contact hole 335b reaching a surface of the anode region 320b are formed simultaneously.

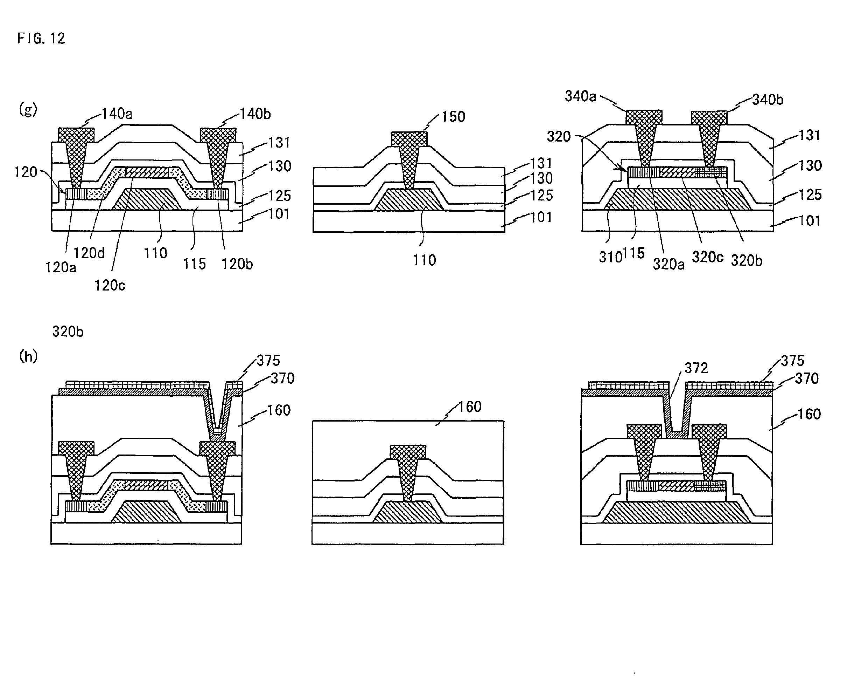

Next, a metal film (not shown) is formed by sputtering on a surface of the second interlayer insulating film 131 and in each of the contact holes 135a, 135b, 155, 335a and 335b. As shown in Fig. 12(g), the metal film is subjected to etching to form a source electrode 140a, a drain electrode 140b and a wiring layer 150 in the TFT 301 and, simultaneously, to form a cathode electrode 340a and an anode electrode 340b in the photodiode 302.

As shown in Fig. 12(h), a contact hole reaching the drain electrode 140b and a recessed portion 372 located above the intrinsic region 320c of the island-shaped silicon layer 320 are formed, and a transparent metal film is formed on the planarizing film 160. The transparent metal film is subjected to patterning to form a pixel electrode 370 which is connected to the drain electrode 140b and covers an inner surface of the recessed portion 372 formed in the photodiode 302. Further, a light shielding layer 375 is formed on the pixel electrode 370 in the TFT 301 and a surface of the pixel electrode 370 located above the cathode electrode 340a and the anode electrode 340b in the photodiode 302. The semiconductor device 300 including the TFT 301 and the photodiode 302 is fabricated as described.

### <3.3 Effects>

It is apparent from the foregoing description that the thickness d1 of the insulating film formed on the source region 120a and the drain region 120b in the channel layer 120, the thickness d2 of the insulating film formed on the gate electrode 110, and the thickness d3 of the insulating film formed on the cathode region 320a and the anode region 320b in the island-shaped silicon layer 320 are equal to one another. Accordingly, it is possible to simultaneously form the contact holes 135a, 135b, 155, 335a and 335b in one step, and therefore to simplify the step of forming the contact holes in the semiconductor device 300.

Moreover, the contact holes 135a, 135b, 155, 335a and 335b are equal in depth to one another. For this reason, at the time of forming the contact hole 155, there is no possibility that the source region 120a in the contact hole 135a, the drain region 120b in the contact hole 135b, the cathode region 320a in the contact hole 335a, and the anode region 320b in the contact hole 335b are thinned excessively or removed entirely. Therefore, it is possible to prevent contact resistance between the source region 120a and the source electrode 140a, contact resistance between the drain region 120b and the drain electrode 140b, contact resistance between the cathode region 320a and the cathode electrode 340a and contact resistance between the anode region 320b and the anode electrode 340b from increasing.

### <4. Modification Examples>

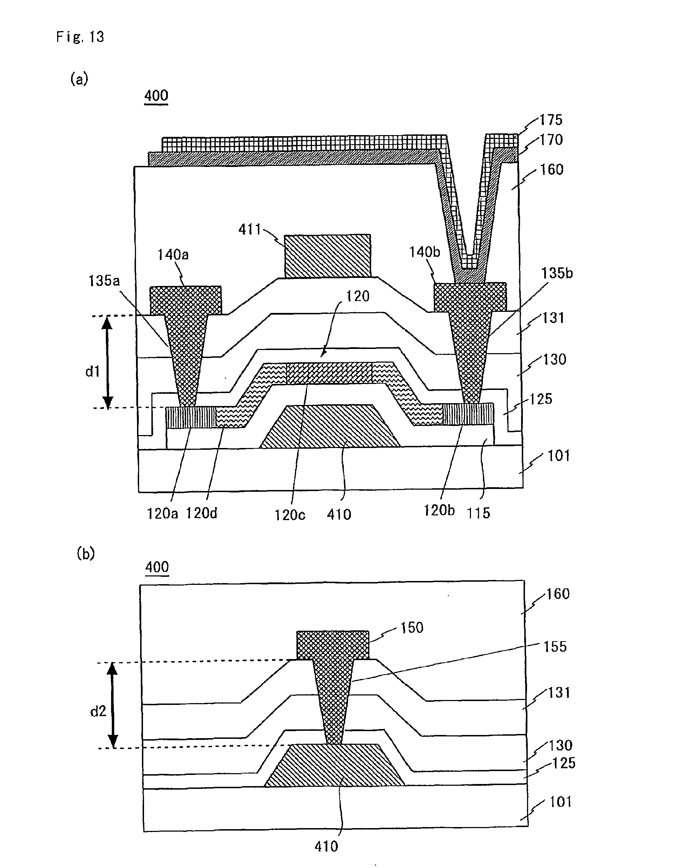

The TFT 100 shown in Figs. 2(a) and 2(b) has, as a gate electrode, only the gate electrode 110 formed on the glass substrate 101. However, a double gate type TFT 400 including two gate electrodes may be used instead of the TFT 100. Figs. 13(a) and 13(b) are section views that show a configuration of the double gate type TFT 400 corresponding to a modification example of the TFT 100 according to the first embodiment shown in Figs. 2(a) and 2(b). The same constituent elements of the double gate type TFT 400 shown in Figs. 13(a) and 13(b) as the constituent elements of the TFT 100 shown in Figs. 2(a) and 2(b) are denoted with the same reference symbols as those of the constituent elements of the TFT 100 shown in Figs. 2(a) and 2(b), and the description thereof is not given here.

As shown in Figs. 13(a) and 13(b), in the double gate type TFT 400, a gate electrode 410 is formed on a glass substrate 101, and a second gate electrode 411 is formed on a second interlayer insulating film 131 so as to be opposed to the gate electrode 410 with a channel layer 120 interposed in between.

The double gate type TFT 400 produces not only the identical effects with those of the TFT 100 according to the first embodiment, but also the following effects. It is possible to stabilize a threshold voltage since a back gate effect is produced by fixation of a voltage to be applied to the second gate electrode 411 at a predetermined voltage. Moreover, it is possible to change the threshold voltage with ease only by changing the voltage to be applied to the second gate electrode 411, without changing a fabricating process of the double gate type TFT 400.

Further, the second gate electrode 411 of the double gate type TFT 400 is formed simultaneously at the time of patterning a metal film made of aluminum or the like to form a source electrode 140a and a drain electrode 140b. Therefore, in the fabricating method described in the first embodiment, it is only required to use a mask on which a pattern for the second gate electrode 411 is also formed, in place of the mask used at the time of forming the source electrode 140a, the drain electrode 140b and the like, and there is no need to provide new additional steps.

### <5. Application to Liquid Crystal Display>

### <5.1 First Application Example>

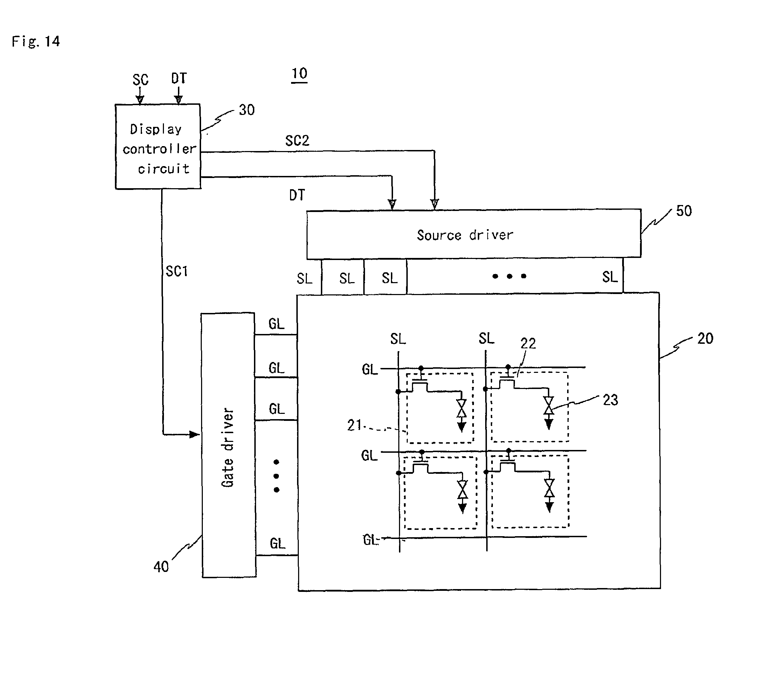

Fig. 14 is a block diagram that shows a configuration of a liquid crystal display 10. As shown in Fig. 14, the liquid crystal display 10 includes a liquid crystal panel 20, a display controller circuit 30, a gate driver 40 and a source driver 50. The liquid crystal panel 20 has a plurality of gate wires GL extending in a horizontal direction, and a plurality of source wires SL extending in a direction intersecting the plurality of gate wires GL. A pixel formation part 21 is arranged in the vicinity of an intersection between the gate wire GL and the source wire SL. The pixel formation part 21 includes a TFT 22 functioning as a switching element, and a liquid crystal capacitance 23 retaining a voltage responsive to an image signal DT for a predetermined period of time. The TFT 22 has a gate electrode connected to the gate wire GL, a source electrode connected to the source wire SL, and a drain electrode connected to a pixel electrode which is one of electrodes of the liquid crystal capacitance 23.

The display controller circuit 30 receives control signals SC such as a horizontal synchronizing signal and a vertical synchronizing signal and an image signal DT from the outside of the liquid crystal display 10. Based on these signals, the display controller circuit 30 outputs a control signal SC1 to the gate driver 40, and also outputs a control signal SC2 and the image signal DT to the source driver 50.

The gate driver 40 is connected to each gate wire GL, and the source driver 50 is connected to each source wire SL. The gate driver 40 transmits to the gate wire GL a HIGH-level signal indicating a selection status. Thus, the gate wires GL are selected sequentially one by one, so that the pixel formation parts 21 on one row are selected collectively. The source driver 50 applies to the source wire SL a voltage responsive to the image signal DT. Thus, the voltage responsive to the image signal DT is written to the selected pixel formation parts 21 on one row. In the liquid crystal display 10, the liquid crystal panel 20 displays an image as described above. Herein, the liquid crystal panel 20 is referred to as a display part in some instances.

It is possible to simplify a step of forming contact holes in the TFT in such a manner that one of the TFT 100 according to the first embodiment, the TFT 200 according to the second embodiment and the TFT 400 corresponding to the modification example is used as the switching element in the pixel formation part 21 of the liquid crystal display 10. For this reason, it is also possible to simplify a manufacturing process of the liquid crystal display 10. As the result, it is possible to reduce a manufacturing cost for the liquid crystal display 10 by shortening a TAT for the liquid crystal display 10 and decreasing the number of photomasks to be used.

### <5.2 Second Application Example>

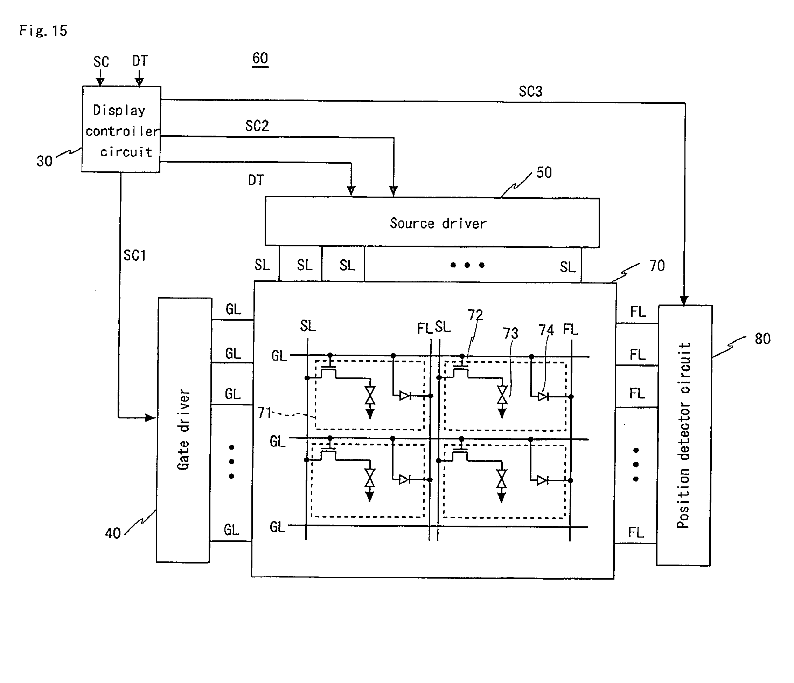

Fig. 15 is a block diagram that shows a configuration of a liquid crystal display 60 having a touch panel function. The liquid crystal display 60 having the touch panel function includes a position detector circuit 80 in addition to the constituent elements of the liquid crystal display 10 shown in Fig. 14. The same constituent elements of the liquid crystal display 60 having the touch panel function as the constituent elements of the liquid crystal display 10 shown in Fig. 14 are denoted with the same reference symbols as those of the constituent elements of the liquid crystal display 10 shown in Fig. 14. Therefore, the same constituent elements will be described briefly and the different constituent elements will be described mainly.

The liquid crystal panel 70 has a plurality of gate wires GL extending in a horizontal direction, and a plurality of source wires SL and a plurality of sensor wires FL extending in parallel to one another in a direction intersecting the gate wires GL. A pixel formation part 71 is arranged in the vicinity of an intersection between the gate wire GL and the source wire SL. The pixel formation part 71 is different from the pixel formation part 21 shown in Fig. 14, and includes a photodiode 74 in addition to a TFT 72 functioning as a switching element and a liquid crystal capacitance 73 retaining an image signal for a predetermined period of time. The photodiode 74 receives light which is emitted from a backlight source (not shown), is reflected from a finger or the like on the liquid crystal panel 70 and is incident into the pixel formation part 71. The photodiode 74 has an anode electrode connected to the gate wire GL, and a cathode electrode connected to the sensor wire FL.

When a predetermined voltage is applied to the gate wire GL, a current flows from the gate wire GL into the sensor wire FL via the photodiode 74 in an amount responsive to the intensity of the light which is incident into the photodiode 74. The position detector circuit 80 detects the current flowing through the sensor wire FL to sense the intensity of the light received by the photodiode 74 and to specify the touched position on the liquid crystal panel 70. Herein, the liquid crystal panel 70 is referred to as a display part in some instances.

It is possible to simplify a step of forming contact holes in the TFT 72 and the photodiode 74 in such a manner that the semiconductor device 300 according to the third embodiment is used as the switching element and the photodiode in the pixel formation part 71 of the liquid crystal display 60 having the touch panel function. Thus, it is possible to simplify a manufacturing process of the liquid crystal display 60 having the touch panel function. As the result, it is possible to reduce a manufacturing cost for the liquid crystal display 60 having the touch panel function, by shortening a TAT for the liquid crystal display 60 having the touch panel function and decreasing the number of photomasks to be used.

### <5.3 Others>

Each of the TFTs according to the respective embodiments is an n-channel type TFT, but may be a p-channel type TFT. In the foregoing description, each of the TFTs 100, 200 and 400 is applied to the liquid crystal display 10, but may be applied to an organic EL (Electro Luminescence) display. In the foregoing description, moreover, the semiconductor device 300 is applied to the liquid crystal display 60 having the touch panel function, but may be applied to an organic EL display having a touch panel function.

### INDUSTRIAL APPLICABILITY

The present invention is suitable for displays such as an active matrix type liquid crystal display and a liquid crystal display having a touch panel function. In particular, the present invention is suitable for a display in which a bottom gate type TFT is used as a switching element in a pixel formation part.

### EXPLANATION OF REFERENCE SYMBOLS

10 ... Liquid crystal display
20, 70 ... Liquid crystal panel (display part)
21, 71 ... Pixel formation part
22, 72 ... TFT (switching element)
60 ... Liquid crystal display having touch panel function
74 ... Photodiode (photoreceptor part)
80 ... Position detector circuit
100, 200, 400 ... TFT (thin film transistor)
101 ... Insulation substrate (glass substrate)
110 ... Gate electrode
115 ... Gate insulating film
120 ... Channel layer
120a ... Source region (n⁺ region)
120b ... Drain region (n⁺ region)
135a, 135b, 155, 235a, 235b, 255 ... Contact hole
140a ... Source electrode
140b ... Drain electrode
300 ... Semiconductor device
301 ... TFT (thin film transistor)
302 ... Photodiode
320 ... Island-shaped silicon layer (island-shaped semiconductor layer)
320a ... Cathode region
320b ... Anode region
335a, 335b ... Contact hole
340a ... Cathode electrode
340b ... Anode electrode

## Claims

1. A bottom gate type thin film transistor formed on an insulation substrate,
the thin film transistor comprising:
a first gate electrode formed on the insulation substrate;
a channel layer formed so as to partially cover the first gate electrode;
a gate insulating film formed below the channel layer;
a source region and a drain region each formed in the channel layer;
a first insulating film formed on surfaces of the source region and drain region;
a second insulating film formed on a surface of the first gate electrode which is not covered with the channel layer;
first contact holes formed in the first insulating film to reach the surfaces of the source region and drain region, respectively; and
a second contact hole formed in the second insulating film to reach the surface of the first gate electrode which is not covered with the channel layer, wherein
the first insulating film is equal in thickness to the second insulating film.

2. The thin film transistor according to claim 1, further comprising
a second gate electrode formed on the first insulating film so as to be opposed to the first gate electrode with the channel layer interposed in between.

3. A method for fabricating a bottom gate type thin film transistor formed on an insulation substrate,
the method comprising the steps of:
forming a gate electrode on the insulation substrate;
forming a gate insulating film so as to cover the insulation substrate together with the gate electrode;
forming a semiconductor film on the gate insulating film;
etching the semiconductor film and the gate insulating film to form a channel layer which partially covers the gate electrode and extends onto the gate insulating film and, simultaneously, to remove the semiconductor film and the gate insulating film on the gate electrode which is not covered with the channel layer;
doping the channel layer with impurities to form a source region and a drain region;
forming an insulating film so as to cover the insulation substrate together with the channel layer and the gate electrode; and
etching the insulating film to simultaneously form first contact holes reaching surfaces of the source region and drain region, respectively, and a second contact hole reaching a surface of the gate electrode from which the gate insulating film is removed.

4. The method for fabricating the thin film transistor according to claim 3, wherein
the step of forming the source region and the drain region includes a step of doping the channel layer with the impurities after etching the semiconductor film to form the channel layer.

5. The method for fabricating the thin film transistor according to claim 3, wherein
the step of forming the source region and the drain region includes a step of doping the semiconductor film with the impurities before etching the semiconductor film to form the channel layer.

6. A semiconductor device comprising:
one insulation substrate;
a thin film transistor formed on the insulation substrate; and
a photodiode having a light shielding film and formed on the insulation substrate, wherein
the thin film transistor includes:
a gate electrode formed on the insulation substrate;
a channel layer formed so as to partially cover the gate electrode;
a gate insulating film formed below the channel layer;
a source region and a drain region each formed in the channel layer;
a first insulating film formed on surfaces of the source region and drain region;
a second insulating film formed on a surface of the gate electrode which is not covered with the channel layer;
first contact holes formed in the first insulating film to reach the surfaces of the source region and drain region, respectively; and
a second contact hole formed in the second insulating film to reach the surface of the gate electrode which is not covered with the channel layer,
the photodiode includes:
the light shielding film formed on the insulation substrate;
an island-shaped semiconductor layer formed on the light shielding film with the gate insulating film interposed in between;
an anode region and a cathode region each formed in the island-shaped semiconductor layer; and
a third insulating film in which third contact holes reaching surfaces of the anode region and cathode region, respectively, are formed, and
the first insulating film, the second insulating film and the third insulating film are equal in thickness to one another.

7. A method for fabricating a semiconductor device in which a thin film transistor and a photodiode having a light shielding film are formed on one insulation substrate,
the method comprising the steps of:
forming a gate electrode of the thin film transistor and the light shielding film on the insulation substrate;
forming a gate insulating film so as to cover the insulation substrate together with the gate electrode and the light shielding film;
forming a semiconductor film on the gate insulating film;
performing patterning on the semiconductor film to form a channel layer, which partially covers the gate electrode and extends onto the gate insulating film, of the thin film transistor and an island-shaped semiconductor layer of the photodiode and, simultaneously, to remove the semiconductor film and the gate insulating film on the gate electrode which is not covered with the channel layer;
forming a source region and a drain region in the channel layer, and forming a cathode region and an anode region in the island-shaped semiconductor layer;
forming an insulating film so as to cover the insulation substrate together with the channel layer, the island-shaped semiconductor layer, and the gate electrode from which the gate insulating film is removed; and
etching the insulating film to simultaneously form first contact holes reaching surfaces of the source region and drain region, respectively, a second contact hole reaching a surface of the gate electrode from which the gate insulating film is removed, and third contact holes reaching surfaces of the cathode electrode and anode electrode, respectively.

8. An active matrix type display for displaying an image, the display comprising:
a display part including a plurality of gate wires, a plurality of source wires intersecting the plurality of gate wires, and a plurality of pixel formation parts arranged in a matrix form in correspondence with intersections between the plurality of gate wires and the plurality of source wires;
a gate driver selectively activating the plurality of gate wires; and
a source driver applying to the source wire an image signal indicating an image to be displayed, wherein
the pixel formation part includes a switching element to be turned on and off in accordance with a signal applied to the corresponding gate wire, and
the switching element is the thin film transistor according to claim 1.

9. An active matrix type display having a touch panel function, the display comprising:
a display part including a plurality of gate wires, a plurality of source wires intersecting the plurality of gate wires, and a plurality of pixel formation parts arranged in a matrix form in correspondence with intersections between the plurality of gate wires and the plurality of source wires, each pixel forming part including the semiconductor device according to claim 6;
a gate driver selectively activating the plurality of gate wires;
a source driver applying to the source wire an image signal indicating an image to be displayed; and
a position detector circuit detecting a touched position on the display part, wherein
each of the plurality of pixel formation parts includes:
a switching element to be turned on and off in accordance with a signal applied to the corresponding gate wire; and
a photoreceptor part outputting to the position detector circuit a signal responsive to the intensity of light to be incident into the pixel formation part,
the switching element is a thin film transistor included in the semiconductor device, and
the photoreceptor part is a photodiode included in the semiconductor device.
